# EUROPEAN PATENT APPLICATION

(11) **EP 4 801 217 A1**
(43) Date of publication of application: **02.09.2026**
(21) Application number: 26160837.6
(22) Date of filing: 26.02.2026
(51) Int. Cl.: H05K 9/00

(54) **SHIELDING ENCLOSURE FOR ELECTRONIC EQUIPMENT**

(30) Priority: 28.02.2025 US 202563764606 P
(71) Applicant: Karl Storz SE & Co. KG, 78532 Tuttlingen (DE)
(72) Inventor: GEISSER, Romana, 78532 Tuttlingen (DE); WEISS, Matthias, 78532 Tuttlingen (DE)

(57) **Abstract**

Shielding enclosure for electronic equipment comprises a cover (80), which has at least four sides. One or more of the four sides includes one or more fingers (90). Each of the fingers (90) includes a base (92) connected with the cover (80) and a front portion. The fingers are cut on three sides from the cover (80), and are configured to frictionally engage through tension a portion of another cover (40) of the enclosure between the cover (80) and each of the fingers (90). The shielding enclosure is particularly configured to provide an EMC shielding for the electronic equipment.

## Description

### TECHNICAL FIELD

The present disclosure refers to an enclosure, or portions thereof, configured to provide EMC shielding, especially for an enclosure providing EMC shielding for an electronic equipment, for example an electronic control unit, particularly a control unit of a medical imaging system.

### BACKGROUND

EMC stands for Electro Magnetic Compatibility, which means that a circuit/device/electronic component has the necessary components/configuration/ construction to provide a shielding. An EMC shielding is, generally speaking, any technology configured to protect signals, for example in an electronic device, from external electromagnetic signals/interference, and/or configured to prevent a signal from egressing from the electronic device causing interference with other surrounding electronic device(s) and/or the environment.

Unwanted electromagnetic energy can reap havoc on electronic devices, and especially sensitive electronic equipment. This unwanted electromagnetic energy has the potential to create a wide variety of different issues from, for example, an induced hiss on a communication line, to a total disruption of mission or safety-critical signal(s). As such, this energy has the potential to impact a wide variety of industrial and consumer sectors, including but not limited to consumer electronics, industrial electronics, military electronics, medical electronics, and the like.

Standards that govern EMC shielding generally fall into two categories. The first are the IEC standards on Electromagnetic compatibility (EMC), which are mostly part of the IEC 61000 family. Some examples of these are IEC/TR EN 61000-1-1, Electromagnetic compatibility (EMC) - Part 1: General - Section 1: Application and interpretation of fundamental definitions and terms, IEC/TR EN 61000-2-1, Electromagnetic compatibility (EMC) - Part 2: Environment - Section 1: Description of the environment - Electromagnetic environment for low-frequency conducted disturbances and signaling in public power supply systems, etc.

The second is CISPR (Comité International Special des Perturbations Radio) or the International Special Committee for Radio Protection of IEC. CISPR Standards are generally directed to emissions in the 9 kHz to 400 GHz range and address interference caused by electronics. Many of the CISPR standards address product emissions and RF rejection requirements as well as provide testing methodologies for compliance.

It is an object of the present invention to provide a shielding enclosure for an electronic equipment that is easy to assemble, provides reliable EMC shielding, allows for reliable functionality of the electronic equipment and improves compatibility with components of an electronic system including the electronic equipment.

### SUMMARY

A shielding enclosure for an electronic equipment according to the present disclosure comprises a cover, which has at least four sides. One or more of the four sides includes one or more fingers. Each of the fingers includes a base connected with the cover and a front portion. The fingers are cut on three sides from the cover and are configured to frictionally engage through tension a portion of another cover of the enclosure between the cover and each of the fingers.

The shielding enclosure, for example, provides an improved cover for an electronic device, especially an electronic device as used in a medical imaging system. Especially, the shielding enclosure is configured to provide electromagnetic shielding.

The shielding enclosure provides an improved cover for an electronic device or equipment that has a simplified construction and material composition.

One aspect of the shielding enclosure is directed to providing an improved monolithic cover for an electronic device that can be substantially (or completely) free of fasteners and is at least partially based on a frictional engagement with another portion of an enclosure.

In accordance with one exemplary aspect, a portion of the cover includes a plurality of metal fingers that exert a force that holds a complementary portion of the cover against another component or cover of the enclosure of the electronic device, such as a lip of a bezel, such as a front or rear bezel.

In accordance with one exemplary embodiment, the cover is stainless steel, and a front portion of the cover includes a plurality of metal fingers that are offset relative to a main plane of the cover thereby defining a gap between a main plane of the cover and the offset metal fingers, wherein a lip of another component or cover is sandwiched and held in the gap.

The cover can optionally include further layers, such as decorative layer(s) affixed to at least one outside portion thereof, such as an outer surface. This decorative layer(s) can be affixed through any known means such as adhesive, rivets, screws, fasteners, molding, and/or any combination thereof.

The cover of the shielding enclosure can optionally have the fingers at one or more edges of the cover, such as the front and back edges.

The exemplary cover exhibits high EMC shielding capabilities while avoiding some of the drawbacks of prior designs such as having multiple (separate) components which required assembly, requiring special coating(s), requiring multiple layers, requiring multiple material types and/or not providing adequate EMC shielding. In an exemplary embodiment of the shielding enclosure each of the fingers may include a chamfer, a ramp and/or a bevel on a front edge of the fingers. Further, the fingers may include one or more of a first knee and a second knee bent at respective angles. Thus, the front edge of the fingers points away from the base of the cover providing a receiving opening for the other cover.

In a further exemplary embodiment of the shielding enclosure a space exists on three sides of the fingers when the cover is viewed in plan view. The space provides easy assembling or connecting of the cover with the other cover. The other cover may comprise a lip for inserting in between the cover and the fingers. A tension force is exerted by each of the fingers to secure the lip of the other cover between the cover and each of the fingers.

In one exemplary embodiment, the shielding enclosure may comprise a chassis, wherein the cover, or two or more sides, of the enclosure can be made from the same piece of material, which reduces assembling efforts. For example, the cover can be stainless steel. The fingers can be die cut. In general, the fingers can be formed in the cover and integral thereto. This supports precise formation of the fingers and defined dimensions thereof.

In a further exemplary embodiment of the shielding enclosure at least a portion of a side of each of the fingers can be in contact with the lip of the another cover, when the enclosure is in an assembled state. For example, in an assembled state at least a portion of an underside of the cover adjacent to each of the fingers can be in contact with the lip of the another cover. Thus, an edge of the cover can be in contact with an edge or the lip of the other cover for reliable connection and shielding.

The shielding enclosure may comprise multiple covers, which may be connected to each other, for example by fingers as described above provided on at least some of the covers.

For example, the shielding enclosure may comprise one or more of a front lip and/or a back lip on the cover for frictionally engaging through tension with a portion of another cover, or serving as a positioning means relative to another cover.

In yet another exemplary embodiment of the shielding enclosure each of the fingers can be bent to form a spring tension upon insertion of the other cover or another component between the fingers and the underside of the cover. One or more of a first knee and a second knee of the fingers can be bent at respective angles relative to the underside of the cover for provide the spring tension.

The preceding is a simplified summary of the disclosure to provide an understanding of some aspects of the shielding enclosure. This summary is neither an extensive nor exhaustive overview of the disclosure and its various aspects, embodiments, and configurations. It is intended to present selected concepts of the disclosure in a simplified form as an introduction to the more detailed description presented below. As will be appreciated, other aspects, embodiments, and configurations of the disclosure are possible utilizing, alone or in combination, one or more of the features set forth above or described in detail below.

Numerous additional features and advantages are described herein and will be apparent to those skilled in the art upon consideration of the following Detailed Description and in view of the accompanying figures.

### BRIEF DESCRIPTION OF THE DRAWINGS

The accompanying drawings are incorporated into and form a part of the specification to illustrate several examples of the present disclosure. These drawings, together with the description, illustrate exemplary principles of the disclosure. The drawings simply illustrate exemplary and alternative examples of how the shielding enclosure can be made and used and are not to be construed as limiting the disclosure to only the illustrated and described examples. Further features and advantages will become apparent from the following, more detailed, description of the various aspects, embodiments, and configurations of the disclosure, as illustrated by the drawings referenced below.

It should be understood that the drawings are not necessarily to scale. In certain instances, details that are not necessary for an understanding of the disclosure or that render other details difficult to perceive may have been omitted. It should be understood, of course, that the disclosure is not necessarily limited to the particular embodiments illustrated herein.
Figure 1 illustrates an exemplary shielding enclosure in accordance with aspects of the present disclosure.
Figure 2 illustrates a top-front perspective view of an exemplary cover in accordance with aspects of the present disclosure.
Figure 3 illustrates a top, upper right-hand side perspective view of an exemplary cover in accordance with aspects of the present disclosure.
Figure 4 illustrates an exploded view of Fig. 3 in accordance with aspects of the present disclosure.
Figure 5 illustrates an exploded view of Fig. 3 in accordance with aspects of the present disclosure.
Figure 6 illustrates a bottom view of an exemplary cover in accordance with aspects of the present disclosure.
Figure 7 illustrates an exploded top view from Fig. 6 in accordance with aspects of the present disclosure.
Figure 8 illustrates an exploded partial view from Fig. 5 in accordance with aspects of the present disclosure.
Figure 9 illustrates a side view of the cover and front bezel engagement in accordance with aspects of the present disclosure.
Figure 10 illustrates another side (partial cross-section) wire-frame view of the cover and front bezel engagement of Fig. 9 in accordance with aspects of the present disclosure.
Figure 11 illustrates a rear perspective view of an exemplary cover in accordance with aspects of the present disclosure.
Figure 12 illustrates a rear perspective view of an exemplary cover engaged with a back cover in accordance with aspects of the present disclosure.
Figure 13 illustrates some of the components in accordance with certain aspects of the present disclosure.

### DETAILED DESCRIPTION

Before any embodiments of the disclosure are explained in detail, it is to be understood that the disclosure is not limited in its application to the details of construction and the arrangement of components set forth in the following description or illustrated in the drawings. The disclosure is capable of other embodiments and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Further, the present disclosure may use examples to illustrate one or more aspects thereof. Unless explicitly stated otherwise, the use or listing of one or more examples (which may be denoted by "for example," "by way of example," "e.g.," "such as," or similar language) is not intended to and does not limit the scope of the present disclosure.

The ensuing description provides embodiments only, and is not intended to limit the scope, applicability, or configuration of the claims. Rather, the ensuing description will provide those skilled in the art with an enabling description for implementing the described embodiments. It being understood that various changes may be made in the function and arrangement of elements without departing from the spirit and scope of the appended claims.

Various aspects of the present disclosure will be described herein with reference to drawings that may be schematic illustrations of idealized configurations.

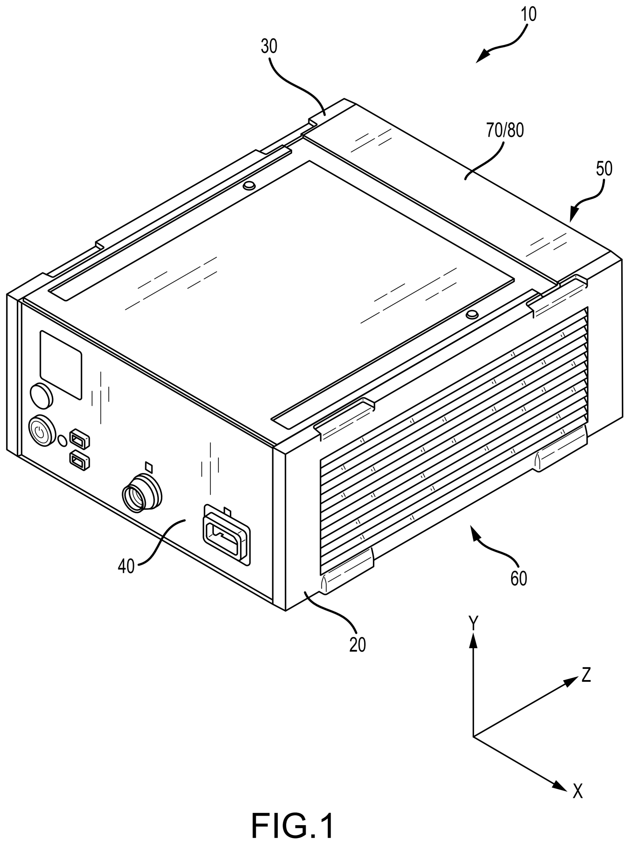

FIG. 1 illustrates an exemplary enclosure in accordance with aspects of the present disclosure. The enclosure 10 includes a right-hand side cover 20, a left-hand side cover 30, a front cover, for example, a front bezel 40, a rear cover, for example, a rear bezel 50 (not shown), a bottom cover 60 (not shown) and a top cover optionally comprised of multiple parts including an outer top cover portion 70 and an inner top cover portion 80.

It is to be appreciated that one or more of the covers and bezels of the enclosure 10 can be singular components, and/or multiple components. For example, in illustrative FIG. 1, the top cover optionally includes a decorative outer top cover 70 over the inner primary EMC shielding inner top cover 80. Here the exemplary inner top cover 80 is made of stainless steel, but other electromagnetic shielding materials can also be used such as, but not limited to: metals (e.g., copper, copper alloy, aluminum, plated metals, plated steel, nickel, monel, Mu-metal, or the like), alloys, polymer carbon composites, polymer ceramic composites, graphene, graphite, and the like.

The inner top cover 80, as described herein, engages with the other covers/bezels of the enclosure 10 to create an EMC shielded enclosure for electronic equipment, such as medical equipment. It is to be appreciated that various covers/bezels can be attached to one another using various means such as fasteners, adhesives, rivets, screws, bolts/nuts, or in general using any known technique or methodology. Additionally, the general construction and configuration of the inner top cover 80 is not limited thereto, and in general the exemplary configuration with fingers could be used with any one or more of the covers/bezels on any one or more of the edges thereof.

However, one of the exemplary advantages of the exemplary inner top cover 80 is that the fingers 90 not only ease assembly through a simple slide-to-fit connection, but also sandwich a portion of the front bezel between the fingers and a main portion of the inner top cover 70, with this snug fit facilitating electromagnetic shielding. Another exemplary advantage is that the choice of stainless steel for the inner top cover 80, with its strength characteristics, allows the length of the fingers to be shortened thereby reducing the gap/spacing around each of the finger cut-outs. This again helps with electromagnetic shielding as areas with no metal through which electromagnetic radiation can escape are reduced. Yet another exemplary advantage is that the inner top cover 80 and fingers 90 can all be made from the same piece of stainless steel, with the fingers stamped therefrom and die cut/bent into the general shape illustrated herein that again facilitates ease of manufacturing, assembly and securing of the front bezel therein.

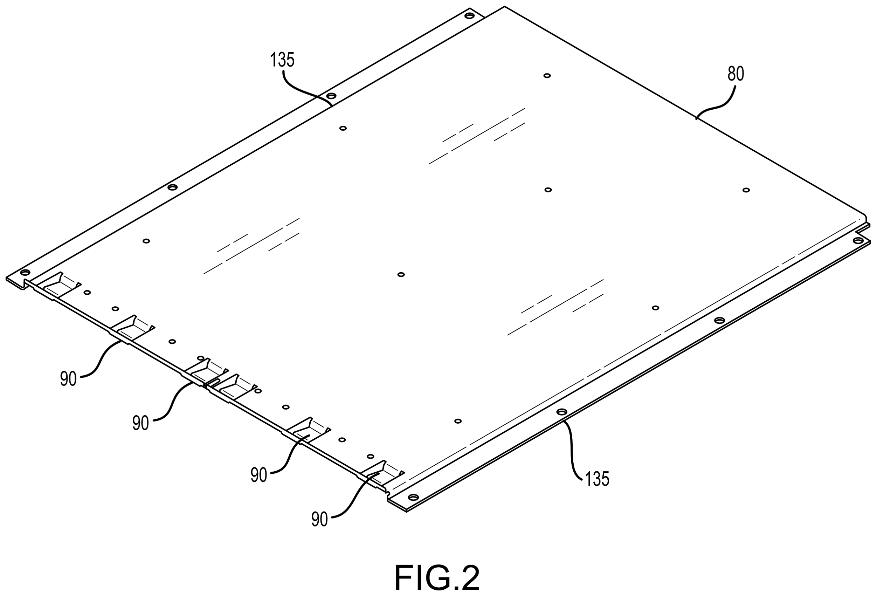

FIG. 2 illustrates a top-front perspective view of an exemplary cover in accordance with aspects of the present disclosure. In FIG. 2, it can be seen that there are 6 exemplary fingers 90, with of course any number of fingers capable of being pressed into the inner top cover 80. Also shown is an exemplary screw hole(s) 135 to allow optional connection, via a fastener, of the inner top cover 80 to another portion of the enclosure 10.

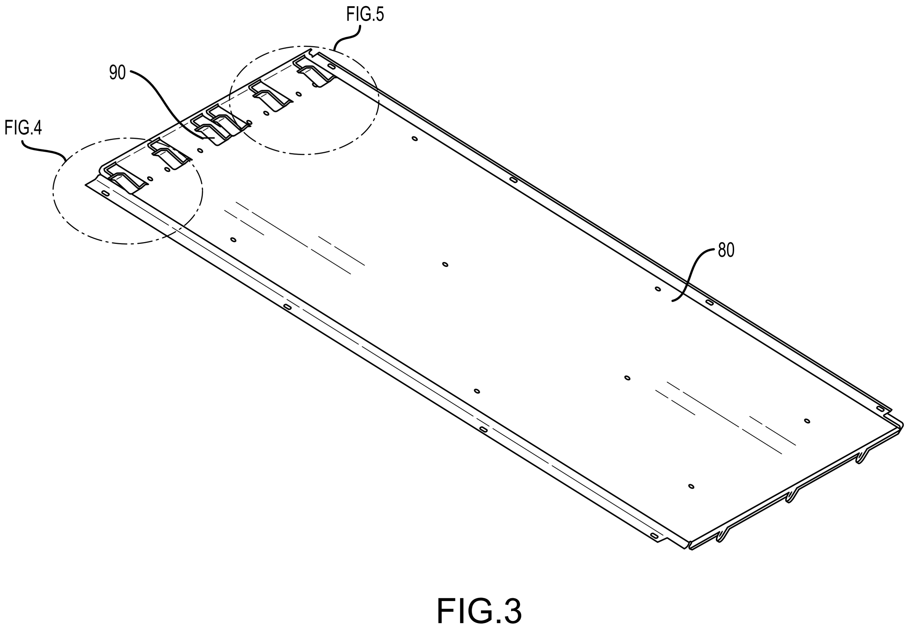

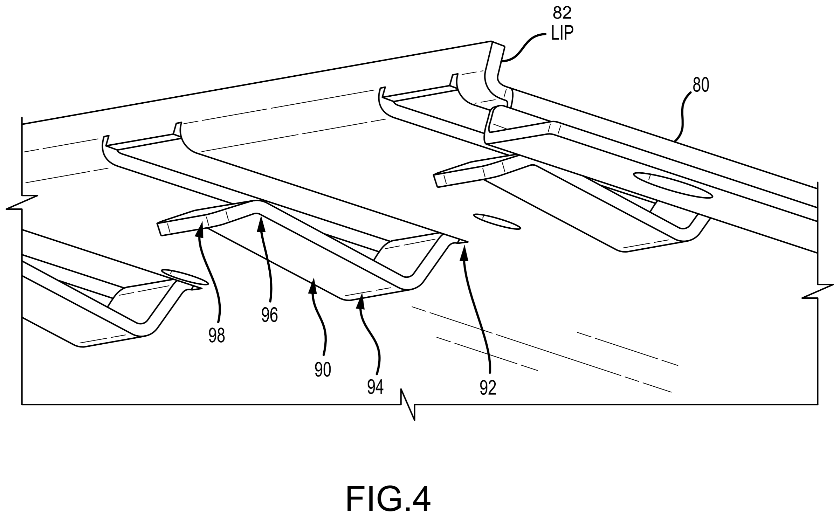

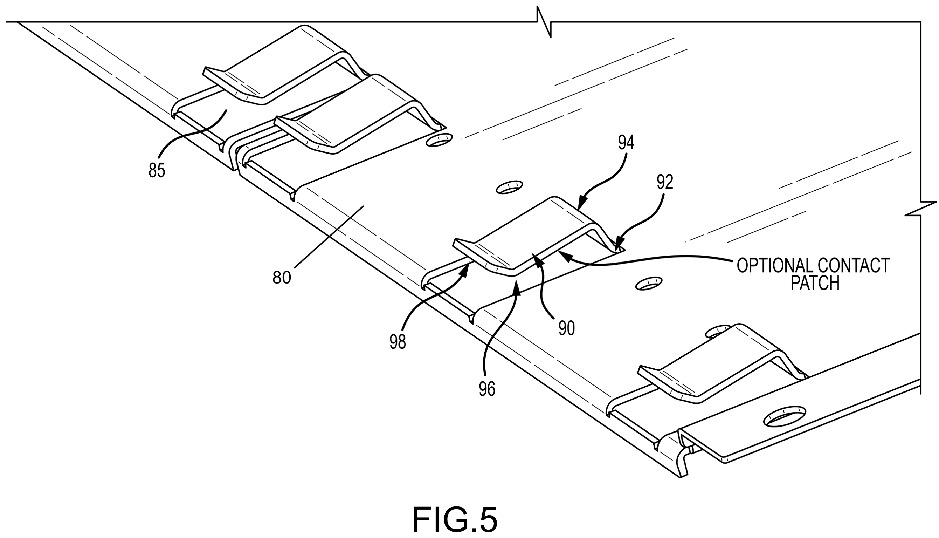

FIG. 3 illustrates a top, upper right-hand side perspective view of an exemplary cover in accordance with aspects of the present disclosure. In this view, the inner top cover 80 shows another angle of the fingers 90, with zoomed-in portions illustrated hereinafter in FIGS. 4 and 5.

In figures 2 and 3, the exemplary inner top cover 80 can be seen with step-down sides and rear cover screw tabs, with all of these features of course being optional. Depending on the specific configuration of the enclosure, other designs are possible that facilitate interconnection of the various components as is well within the skill of a person of ordinary skill in the art.

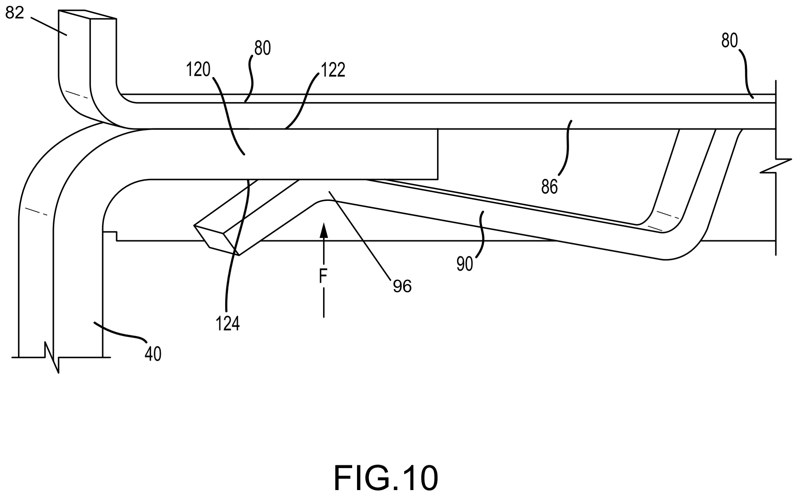

FIG. 4 illustrates an exploded solid view from FIG. 3 in accordance with aspects of the present disclosure. Here, the die-pressed configuration of the fingers is shown. The exemplary fingers 90 each include a finger base 92, a finger first knee 94, a finger second knee 96 and a finger front lip 98, which provides a front edge of the fingers. The formation and die pressing of the fingers results in a gap 85 (discussed hereinafter as receiving the lip from the front bezel) as well as a cut-out 100 (Seen better in FIG. 10) from the base material of the inner top cover 80 where the fingers were stamped. The formation of the fingers 90 and subsequent die stamping creates a spring tension as the fingers are moved to increase the size of the gap 85. This tension helps eliminate any space between the bottom surface 86 of the inner top cover 80 and a top surface 122 of the lip of the front bezel 40 (as shown in FIG. 10), and between the bottom surface 124 of the lip of the front bezel 40 and the surface 88 of finger second knee 96.

While exemplary angles and configurations are shown for the exemplary fingers 90, it is to be appreciated that deviations from these configurations/angles are certainly possible while still maintaining the overall functionality discussed herein. As just some examples, the fingers could be wider, narrower, longer, shorter, and/or have a different shape when viewed in cross-section or plan view provided the shielding and receiving of the front bezel functionality are maintained. Similarly, the front lip 98 could alternatively or in addition be more horizontal and (more or completely) aligned with the plane along the x-z-axis of the large portion of the inner top cover 80 with a chamfer, bezel, and/or radius, or the like.

Optionally, the inner top cover 80 could also include a lip 82 (that extends upward or downward) on the front face configured to abut the front bezel. (Shown in FIG. 10 extending upward.)

FIG. 5 illustrates an exploded solid view from FIG. 3 of the bottom front of the inner top cover 80 in accordance with aspects of the present disclosure, and FIG. 4.

The spring tension to hold the lip of the front bezel is primarily present at the finger base 92. While in one embodiment the underside of the second knee 96 is the primary portion that comes into contact with the lip of the front bezel, it is to be appreciated that the angles of the finger could be varied (primarily the angle of the first knee 94) such that more of less of the optional contact patch (on the underside of the finger 90) shown in FIG. 5 could come into contact with the lip of the front bezel.

Optionally or in addition, the edge of the front bezel could abut against the finger base, which may serve as a stopper when pushing the top cover onto the bezel. This may help with positioning of the top cover. Similarly, the front tip of the finger could abut the front bezel for positioning.

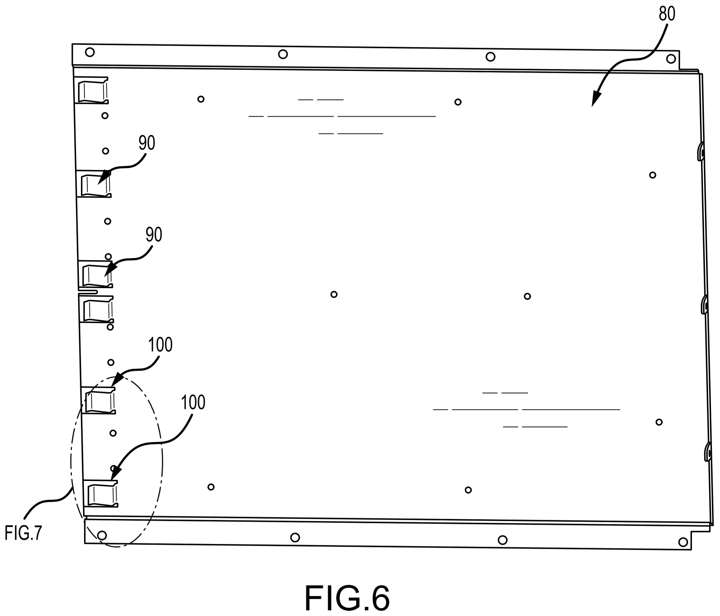

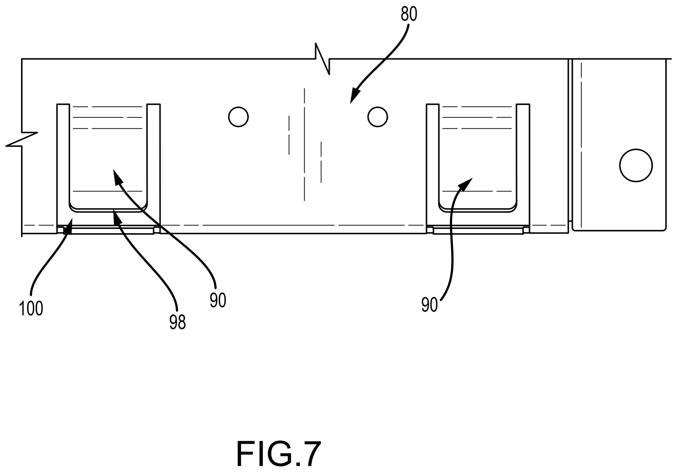

FIG. 6 illustrates a bottom plan view of an exemplary cover in accordance with aspects of the present disclosure. In this view, as well as in FIG. 7 the cutout around each of the fingers 90 is more clearly visible. While this cutout 100 is shown with certain spacing around the fingers 90, it is to be appreciated that the dimensions and clearances of this cutout can be varied to create either more or less space around the fingers, and the spaces around each finger do not need to be the same.

FIG. 7 illustrates an exploded view from FIG. 6 in accordance with aspects of the present disclosure. The finger cutout 100 is more clearly seen in these views. While the fingers 90 are shown not extending fully to the front edge of the inner top cover 80, it is to be appreciated, as discussed, that the length of the fingers 90 can be varied and could extend to the front edge of the inner top cover 80. Exemplary design considerations for the length of the fingers 90 could be one or more of: holding force, material strengths, assembly factors, number of fingers, and the like.

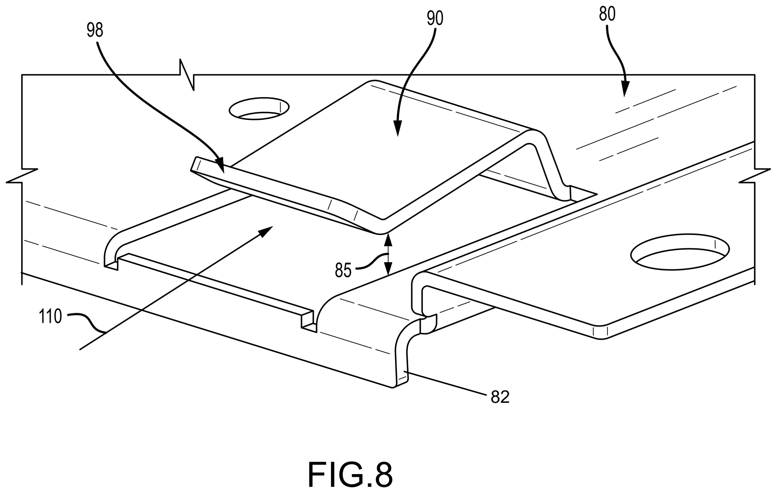

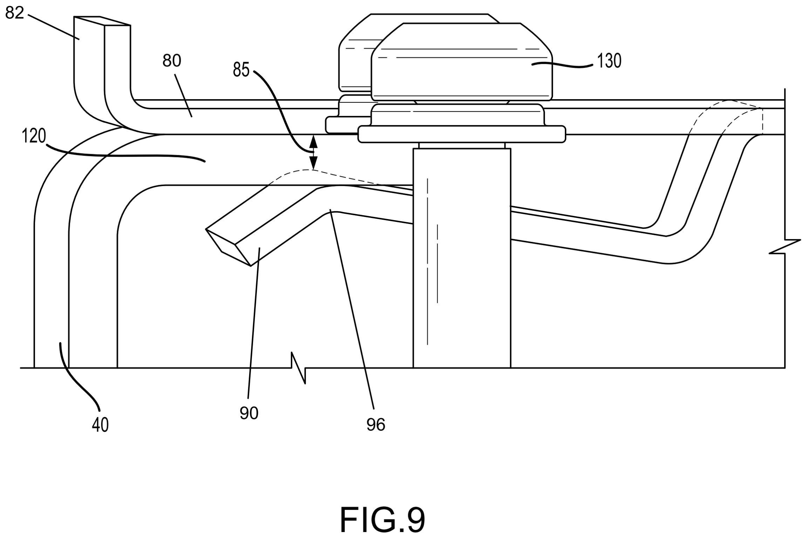

Regarding assembly, FIG. 8 illustrates an exploded partial view from FIG. 6 in accordance with aspects of the present disclosure. In FIG. 8, the insertion direction 110 for the lip of the front bezel is shown. As discussed, the lip of the front bezel (shown assembled in FIGS. 9-10) is slid between the underside of the inner top cover 80 and under the second knee 96 into gap 85. Optionally, the lip of the front bezel is slid substantially to the rear of the finger 90 adjacent to the finger base 92.

FIG. 9 illustrates an exemplary engagement between the cover and a front bezel viewed from the left back under-side in accordance with aspects of the present disclosure. In FIG. 9, the front bezel lip 120 has been installed/inserted into the inner top cover 80 and secured by the fingers. Of note, this exemplary configuration does not require any fasteners. However, optional fasteners and/or adhesive(s) could be added during the assembly process,

The front bezel lip 120 can be seen sandwiched between the bottom of the inner top cover 80 and the finger(s) 90. Of note, in this exemplary embodiment, there is little to no gap between the surface of the front bezel lip 120 that contacts the underside of the inner top cover 80 in the areas where there are no cutouts for the fingers 90. As discussed, this helps improve the shielding characteristics of the enclosure 10.

FIG. 9 illustrates a side view of the cover and front bezel engagement in accordance with aspects of the present disclosure. FIG. 10. illustrates another side (partial cross-section) wire-frame view of the cover and front bezel engagement in accordance with aspects of the present disclosure.

In FIGS. 9-10, the gap 85 has been filled by the front bezel lip 120, deflecting the fingers 90 thereby frictionally sandwiching the front bezel lip 120 in the inner top cover 80. Optional fasteners 130 are shown that can be used to secure the side(s)s of the inner top cover 80 to the side covers via fastener holes 135 (seen in FIG. 2). A snug fit can be achieved and space between the bottom surface 86 of the inner top cover 80 and a top surface 122 of the lip of the front bezel 40 virtually eliminated due to the tension (shown by force arrow F) applied by the fingers 90 on the bottom surface 124 of the lip of the front bezel 40 and the surface 88 of finger second knee 96.

FIG. 10 further illustrates a side view of the cover and front bezel engagement of FIG. 9 in accordance with aspects of the present disclosure. Here, the front bezel lip 120 only extends partially to the back of the finger slot, but, as discussed, the length of the front bezel lip could be adjusted to extend any amount underneath the fingers 90. Similarly, the depth/length of the fingers could be altered to change the extent of engagement with the front bezel lip.

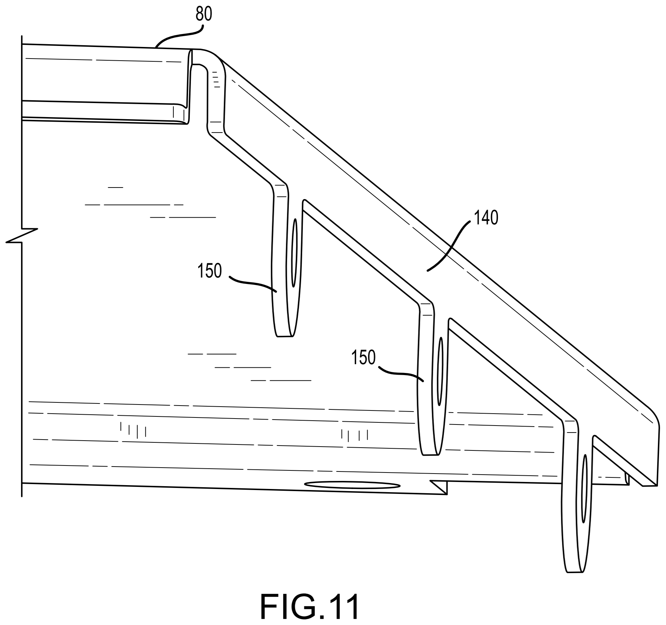

FIG. 11 illustrates a rear perspective view of an exemplary cover in accordance with aspects of the present disclosure. The inner top cover 80 can optionally further include a back lip 140 with one or more screw (or comparable) tabs 150. The addition of fasteners to the screw tabs can assist with pushing the lip of the front bezel into the inner top cover 80 when the enclosure 10 is fully assembled. Alternatively, the lip 140 can be a solid piece (instead of screw tabs) extending substantially across the rear of the cover and can include one or more fastener holes.

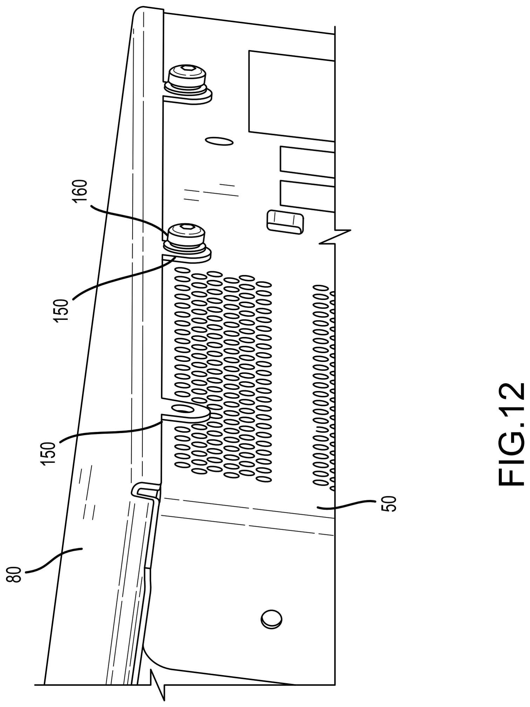

FIG. 12 illustrates a rear perspective view of an exemplary cover engaged with a back cover in accordance with aspects of the present disclosure.

Specifically, FIG. 12 shows a partially assembled state where the inner top cover 80 has been placed over the rear bezel 50, and the two parts have been secured with fasteners 160. While not shown, the rear bezel 50 can be made from the same piece of material as the bottom cover thereby forming a chassis onto which the front bezel, top cover(s), rear bezel and side covers are attached.

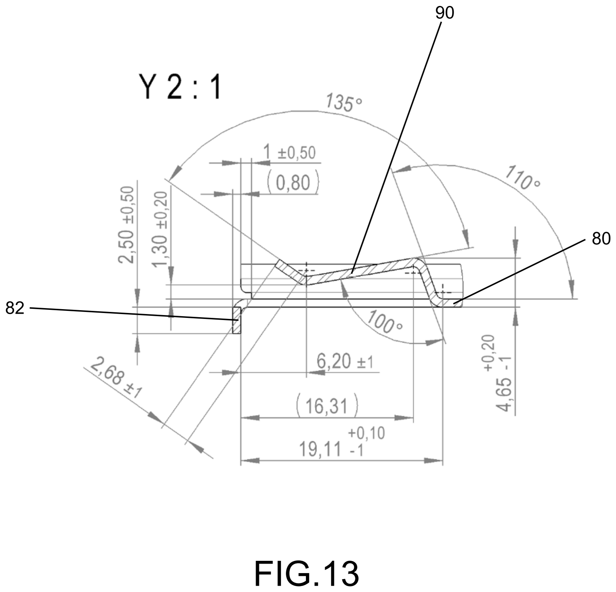

In accordance with one exemplary, non-limiting, embodiment of a cover of a shielding enclosure comprising one or more fingers, the dimensions (in mm) and angles of the various components are shown in FIG. 13. In an advantageous embodiment, the fingers are approximately 15mm in overall length. By forming the angles in the fingers, the front edge of the fingers is retracted from the front edge of the cover. Thus the front edge of the cover can be placed on the other cover, respectively a lip thereof, for guiding the front edge of the fingers below the other cover or its lip resulting in reliable and secure positioning and assembling of the enclosure.

Alternatively, while the enclosure is shown having the front bezel engage on a specific side of the cover, it is to be appreciated that the front bezel could engage on the opposite side of the cover with the fingers being on an "outside" instead of the "inside" of the enclosure.

Although the figures are largely shown in solid lines, it should be understood that one or more aspects of the shielding enclosure 10 may not form part of the claimed invention or design but rather is only a portion of an environment surrounding the claimed invention or design and/or a portion of an environment in which the claimed invention or design operates. In one non-limiting example, any or all of the covers other than inner top cover 80 may not form part of the claimed invention or design but rather is only a portion of an environment surrounding the claimed invention or design and/or a portion of an environment in which the claimed invention or design operates. Therefore, the description through the present disclosure should not be interpreted as a limitation on the scope of the present disclosure but merely an illustration.

The exemplary systems and methods of this disclosure have been described in relation to an enclosure. However, to avoid unnecessarily obscuring the present disclosure, the preceding description may omit a number of known structures and devices. This omission is not to be construed as a limitation of the scope of the claimed disclosure. Specific details are set forth to provide an understanding of the present disclosure. It should, however, be appreciated that the present disclosure may be practiced in a variety of ways beyond the specific detail set forth herein.

References in the specification to "an aspect," "one embodiment," "an embodiment," "an example embodiment," "some embodiments," etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in conjunction with one embodiment, it is submitted that the description of such feature, structure, or characteristic may apply to any other embodiment unless so stated and/or except as will be readily apparent to one skilled in the art from the description.

The foregoing discussion of the disclosure has been presented for purposes of illustration and description. The foregoing is not intended to limit the disclosure to the form or forms disclosed herein. In the foregoing Detailed Description for example, various features of the disclosure are grouped together in one or more embodiments, configurations, or aspects for the purpose of streamlining the disclosure. The features of the embodiments, configurations, or aspects of the disclosure may be combined in alternate embodiments, configurations, or aspects other than those discussed above.

It is to be appreciated that any feature described herein can be claimed in combination with any other feature(s) as described herein, regardless of whether the features come from the same described embodiment.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and this disclosure.

Unless otherwise indicated, all numbers expressing quantities, dimensions, conditions, ratios, ranges, and so forth used in the specification and claims are to be understood as being modified in all instances by the term "about" or "approximately." Accordingly, unless otherwise indicated, all numbers expressing quantities, dimensions, conditions, ratios, ranges, and so forth used in the specification, figures and claims may be increased or decreased by approximately 5% to achieve satisfactory results. Additionally, where the meaning of the terms "about" or "approximately" as used herein would not otherwise be apparent to one of ordinary skill in the art, the terms "about" and "approximately" should be interpreted as meaning within plus or minus 5% of the stated value.

### REFERENCE NUMBERS

10 - Enclosure
20 -Side Cover
30 -Side Cover
40 - Front Cover
50 - Rear Cover
60 - Bottom Cover
70 - Outer Top Cover
80 - Inner Top Cover
82 - Lip
85 - Gap
86 - bottom surface
90 - Finger
92 - Finger Base
94 - Finger first Knee
96 - Finger Second Knee
98 - Finger Front Lip
100 - Finger Cut Out
110 - Insertion Direction for Front Cover
120 - Front Cover Lip
130 - Fastener
140 - Rear Cover Lip
150 - Rear Cover Screw Tab
160 - Fastener

## Claims

1. Shielding enclosure for electronic equipment comprising:
a cover (80);
the cover (80) having at least four sides, one or more of the four sides including one or
more fingers (90), wherein each of the fingers (90):
includes a base (92) connected with the cover (80) and a front portion, are cut on three sides from the cover (80), and
are configured to frictionally engage through tension a portion of another cover (40) of the enclosure between the cover (80) and each of the fingers (90).

2. Shielding enclosure according to claim 1, wherein the another cover (40) includes a lip (120) that extends into a gap (85) present between each of the fingers (90) and an underside of the cover (80).

3. Shielding enclosure according to claim 1 or 2, wherein each of the fingers (90) include a chamfer, a ramp and/or a bevel on a front edge of the fingers.

4. Shielding enclosure according to any of the preceding claims, wherein each of the fingers (90) include one or more of a first knee (94) and a second knee (96) bent at respective angles.

5. Shielding enclosure according to any of the preceding claims, wherein a space exists on three sides of the fingers (90) when the cover (80) is viewed in plan view.

6. Shielding enclosure according to any of the preceding claims, wherein a tension force is exerted by each of the fingers (90) to secure the lip (120) of the another cover (40) between the cover (80) and each of the fingers (90).

7. Shielding enclosure according to any of the preceding claims, wherein the fingers (90) are die cut.

8. Shielding enclosure according to any of the preceding claims, wherein at least a portion of a side of each of the fingers (90), in an assembled state, is in contact with the lip (120) of the another cover (40).

9. Shielding enclosure according to any of the preceding claims, wherein at least a portion of an underside of the cover (80) adjacent to each of the fingers (90), in an assembled state, is in contact with the lip (120) of the another cover (40).

10. Shielding enclosure according to any of the preceding claims, wherein the enclosure is configured to provide electromagnetic shielding.

11. Shielding enclosure according to any of the preceding claims, further comprising one or more of screw tabs and fastener holes configured to secure the cover (80) to one or more other portions of the enclosure.

12. Shielding enclosure according to any of the preceding claims, further comprising one or more of a front lip (82) and/or a back lip on the cover (80).

13. Shielding enclosure according to any of the preceding claims, wherein the cover is stainless steel.

14. Shielding enclosure according to any of the preceding claims, wherein the fingers (90) are formed in the cover (80) and integral thereto.

15. Shielding enclosure according to any of the preceding claims, wherein each of the fingers (90) are bent to form a spring tension upon insertion of another component between the fingers (90) and an underside of the cover (90).
